(19) Europäisches Patentamt
European Patent Office
Office européen des brevets

(11) Publication number: **0 351 234**
**A2**

(12) **EUROPEAN PATENT APPLICATION**

(21) Application number: **89307165.4**

(51) Int. Cl.$^5$: **G 06 F 9/46**

(22) Date of filing: **14.07.89**

(30) Priority: **15.07.88 US 219621**

(43) Date of publication of application:
**17.01.90 Bulletin 90/03**

(84) Designated Contracting States:
**AT BE CH DE ES FR GB GR IT LI LU NL SE**

(71) Applicant: **DIGITAL EQUIPMENT CORPORATION**
**111 Powdermill Road**
**Maynard Massachusetts 01754-1418 (US)**

(72) Inventor: **Kardon, Michael S.**
**14 Elm Street**
**West Boxlston Massachusetts 01583 (US)**

**Leeds, Leonard**
**18 Gail Avenue**
**Bellingham Massachusetts 02019 (US)**

**Young, Carol Ann**
**8 Bristol Street**
**Nashua New Hampshire 03060 (US)**

**Clark, Leroy K.**
**50 Atwood Road**
**Southboro Massachusetts 01772 (US)**

(74) Representative: **Goodman, Christopher et al**
**Eric Potter & Clarkson 14 Oxford Street**
**Nottingham NG1 5BP (GB)**

(54) **Systems for facilitating communications among asynchronously executing processes in digital data processing system.**

(57) A system comprises a spreadsheet application, an external application and a communications system, which includes an associated symbolic entry table for associating symbolic names with cells, for transferring messages between the spreadsheet application and the external application. The external application includes a message generator for generating messages, each having a symbolic name and identifying an operation and a message transfer section for transferring messages generated by said message generator over said communications system. The spreadsheet application includes a message transfer section for receiving messages from said communications system and a message processor for using the contents of the symbolic entry table associated with the communications system over which the message was received for identifying a cell in response to a symbolic name in a message and for performing the operation specified in said message in connection with the identified cell.

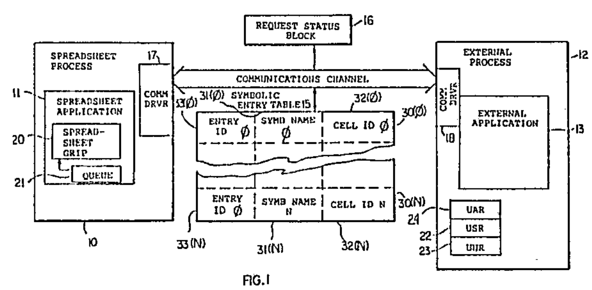


FIG.1

EP 0 351 234 A2

**Description**

## BACKGROUND OF THE INVENTION

The invention relates generally to the field of digital data processing systems, and more specifically to systems for facilitating communications among processes which are executed asynchronously by a digital data processing system. The invention is particularly useful in, for example, facilitating communications between a spreadsheet program, in one process, and other programs, in other processes, to enable the other processes to load data into, and retrieve data from, identified cells of the spreadsheet grid.

Spreadsheet programs have been used for a number of years to facilitate modeling in financial and accounting operations, as well as in other areas, such as process and manufacturing control, scientific data gathering and modeling, and so forth. A spreadsheet program provides a spreadsheet grid, which is a multi-dimensional grid having a number of storage locations, or cells, with each cell being identified by an identifier which essentially identifies the location of the cell in the grid along each of the dimensions. An operator may load data into particular cells and formulas into other cells which define calculations relating the contents of selected cells in particular ways. The operator may then enable the spreadsheet program to perform calculation operations in connection with the formulas and display the results of the calculations in the cells associated with the formulas.

Spreadsheet programs facilitate automation of two major operations in processing information. First, spreadsheet programs assist in generating reports relating current or past activity. In financial applications, for example, a spreadsheet program can assist in generating reports such as profit and loss statements and general ledgers, if actual current or historical financial data is loaded into the spreadsheet grid. A perhaps more powerful use of a spreadsheet program, however, is in connection with planning or hypothetical modeling. If an operator inserts hypothetical data in selected cells, the results of the calculations based on formulas which are based on the contents of those cells can show the changes in the expected results in response to the changes in the data.

While spreadsheet programs can be run separate and apart from other applications, recently it has been recognized that they may be part of a more extensive system, including automated data acquisition applications and automated report generation applications. Currently, these applications are run in conjunction with a spreadsheet session as part of the same process. To start up the other application, the spreadsheet session is suspended, and the other application is started. The other application may insert data into, or retrieve data from the spreadsheet grid, which is provided by the spreadsheet program. After the operator has finished with the other application, he exits it and returns to the spreadsheet application. The spreadsheet program then resumes processing where it had left off.

## SUMMARY OF THE INVENTION

The invention provides a new and improved system for facilitating communications between, for example, a spreadsheet program, which operates in one process, and one or more external applications programs each of which operates in respective other processes. The system permits an operator, operating in a spreadsheet session, to initiate processing of one or more external applications programs and to enable them to provide data to or retrieve data from the spreadsheet application, while facilitating concurrent processing of the spreadsheet program and external applications programs.

In brief, the system comprises a spreadsheet application, an external application and a communications system, which includes an associated symbolic entry table for associating symbolic names with cells, for transferring messages between the spreadsheet application and the external application. The external application includes a message generator for generating messages each having a symbolic name and identifying an operation and a message transfer section for transferring messages generated by said message generator over said communications system. The spreadsheet application includes a message transfer section for receiving messages from said communications system and a message processor for using the contents of the symbolic entry table associated with the communications system over which the message was received for identifying a cell in response to a symbolic name in a message and for performing the operation specified in said message in connection with the identified cell.

The system permits the operator to enable the spreadsheet application to receive data from the external application for storage in the spreadsheet cells, or to transmit data from the spreadsheet cells to the external application without requiring the operator to exit the spreadsheet session, that is, without requiring the operator to temporarily stop execution of the spreadsheet application and commence execution of the external application. In addition, the communications system permits the external application to enable the spreadsheet application to enable the spreadsheet application to establish watchpoints in connection with the values in the spreadsheet cells and notify it when those values have changed. The system accordingly permits the operator to concurrently process both the spreadsheet application and the external application in a multi tasking manner, which provides some substantial benefits

## BRIEF DESCRIPTION OF THE DRAWINGS

This invention is pointed out with particularity in the appended claims. The above and further advantages of this invention may be better understood by referring to the following description taken in conjunction with the accompanying drawings, in which:

Fig. 1 is a functional block diagram of a system including the invention;

Figs. 2A through 2E comprise flow diagrams that detail communications between elements of the system depicted in Fig. 1.

## DETAILED DESCRIPTION OF AN ILLUSTRATIVE EMBODIMENT

Fig. 1 depicts a functional block diagram of a system including the invention. With reference to Fig. 1, the system facilitates communications between a process 10 within which an application 11, such as spreadsheet application program, is executed by a conventional digital data processing system (not shown), and one or more external processes 12, within which external applications 13 are executed by the digital data processing system. The system provides communications drivers 17 and 18 that form part of the respective processes 10 and 12. The communications drivers 17 and 18 jointly provide a communications channel 14 for transferring messages between the spreadsheet process 10 and each external process 12 for enabling the external application 13 to transfer data to, or retrieve data from, the spreadsheet application 11. In performing message transfers, the system makes use of a symbolic entry table 15 associated with a communications channel 14, and request status blocks 16, one of which is shown in Fig. 1, as described below.

As is conventional, the spreadsheet application provides a spreadsheet grid 20 which includes a plurality of cells in which data or formulas may be stored. Each cell is identified by a cell identifier which uniquely identifies the cell in the grid. An operator in a spreadsheet session executing the spreadsheet process can, by means of a conventional data entry device such as a keyboard (not shown) load data into selected cells and formulas into other cells. A formula in a cell normally identifies mathematical relationships using values stored in other cells, the other cells being identified in the formula by their cell identifications. Each formula represents a calculation using values that the operator has loaded into other cells or values computed in response to other formulas which are stored in other cells identified in the particular formula. The values in the respective cells of the spreadsheet grid 20, including the processed data representing results of the computations identified by the formulas, can be displayed on a conventional output device, such as a video display terminal (not shown) or printed on a printer (also not shown).

The communications system permits the operator to enable the spreadsheet process 10 to receive data from the external process 12 for storage in the spreadsheet cells, or transmit data, including processed data, from the spreadsheet cells to the external process 12, without requiring the operator to exit the spreadsheet session, that is, without requiring the operator to temporarily stop execution of the spreadsheet application 11 and commence execution of the external application 13. In addition, the communications system permits the external application 13 to enable the spreadsheet application to establish watchpoints in connection with the values in the spreadsheet cells and notify it when those values have changed. The system accordingly permits the operator to concurrently process both the spreadsheet application 11 and the external application 13 in a multi-tasking manner, which provides some substantial benefits.

For example, if the spreadsheet application 11 is being used in processing financial information relating to securities such as stocks, and the external application 13 provides current stock information from a radio or telecommunications link, it may be desirable to process both the spreadsheet application 11 and the communications application, as external application 13, concurrently, so that the spreadsheet grid 20 may constantly contain current data. A second external process 12 may contain an application which triggers securities sales or purchases in response to the values of certain relationships as defined by formulas in the spreadsheet grid, and may establish watchpoints in connection with those cells. Since some of the data in the spreadsheet grid may represent computations based on formulae in selected spreadsheet cells, it will be desirabel to permit the spreadsheet application 11 to constantly update the computations contemporaneously with the transfer of data to the spreadsheet from the first external process 12, and to notify the second process when the computations defined by the formulas have reached predetermined values defined by the watchpoints so that it may perform the selected operations. Since the communications system permits the two external applications 13 and the spreadsheet application 11 to all be executed concurrently, these operations also occur concurrently.

As described above, the communications system makes use of a symbolic entry table 15 associated with each communications channel 14 in performing message transfers The symbolic entry table 15 provides a mapping between a symbolic name and a spreadsheet cell, permitting messages to and from the external application 13 to identify data by a symbolic name. The symbolic entry table includes one or more entries 30(0) through 30(N) (generally identified by reference numeral 30) each including an entry identification field 33(0) through 33(N) (generally identified by reference numeral 33), a symbolic name field 31(0) through 31(N) (generally identified by reference numeral 31) and a cell identification field 32(0) through 32(N) (generally identified by reference numeral 32).

Messages from the external application 13 to the spreadsheet application 11, or from the spreadsheet application 11 to the external application include a symbolic name, and the spreadsheet application 11 uses the contents of the symbolic entry table 15 to associate the symbolic name with the cells of the spreadsheet grid 20. Thus, if a message from an external application 13 contains data for storage in a cell in the spreadsheet grid 20, the message contains an entry identification. The spreadsheet application 11 identifies from the symbolic name table 15 an entry 30, the contents whose entry identification field 31 matches the entry identification in the message. If the spreadsheet application 11 identifies such an entry 30, it stores the data in the message in the cell in the spreadsheet grid 20 identified by the contents of the cell identification field 32 of the entry 30.

Similarly, if a message from an external application 13 requests data from the spreadsheet grid 20, the message identifies the requested data by means of an entry identification The spreadsheet application 11 identifies from the symbolic name table 15 an entry 30, the contents whose entry identification field 31 matches the entry identification in the message. If the spreadsheet appiication 11 identifies such an entry 30, it retrieves the data in the message in the cell in the spreadsheet grid 20 identified by the contents of the cell identification field 32 of the entry 30 and returns it to the external application 13.

Each message further contains the identification of a status request block 16. The status request block 16 permits the spreadsheet application 11 to notify the external application 13 of the status of a command which may be contained in a message. The status may indicate that the operation defined by the command has been completed, that it has not yet been completed, or that it cannot be completed and the reason. An operation specified in a command in a message may be delayed in being completed because, for example, the spreadsheet application 11 may be performing a recalculation operation in connection with the formulas contained in the cells in the spreadsheet grid 20. When that occurs, if a command references a cell relating to the recalculation operation, it is loaded into a command queue 21 for execution after the recalculation operation.

In one particular embodiment, reasons that the spreadsheet application 11 may not complete an operation divide into three general categories. First, the spreadsheet application may not be able to properly complete an operation because of problems with an entry identification in the message. If, for example, the symbolic entry table 15 associated with a communications channel 14 over which a message is transferred does not contain an entry 30 the contents of whose entry identification field 31 match the entry identification in a message, the operation identified in the message cannot be completed. Similarly, if the symbolic entry table has such an entry 30 but its cell identification field 32 is empty, the operation also cannot be completed.

Second, if the message contains an entry identification for which the symbolic entry table 15 contains a cell identification, the spreadsheet application 11 may not be able to load data into the cell because the cell is locked. When that occurs, the spreadsheet application 11 returns notification of that in the request status block 16 identified in the message.

Finally, the spreadsheet application 11 may return status in the request status block 16 indicating problems with data transferred to the external application 13 from a cell in the spreadsheet grid 20. For example, the spreadsheet application 11 may have had to truncate the data in the return message. The status returned in the request status block 16 may indicate the truncation.

With this background, the operations performed by the external application 13 and the spreadsheet application 11 in connections with communications over a communications channel 14 will be described in connection with Figs. 2A through 2E. With reference to Fig. 2A, the external application 13 initially generates an initialization directive to the communications driver 18 (step 100), which in one embodiment may include a pointer to a user status routine 22 and a user verification routine 23. The user verification routine 23 may limit access to a particular symbolic entry table which the external application subsequently generates for use in connection with the communications channel 14. The user status routine 22 contains routines for processing status information which is received from the communications channel 14, and, specifically, from the spreadsheet application 11.

Prior to establishment of a communications channel 14 between the spreadsheet process 10 and external process 12, the external application 13 enables the communications driver 18 to establish the symbolic entry table 15 and load symbolic names and cell identifications into respective fields 31 and 32 in entries 30 (steps 101 through 105). The contents of the entries 30 may be supplied directly by the external application 13, or they may be supplied by the contents of a previously established file stored on disk. If the contents of the entries 30 are to be supplied by the contents of a disk file, the external application 13 identifies the disk file to the communications driver 18 after enabling it to create the symbolic entry table 15. Similarly, if the contents of the symbolic entry table 15 are supplied directly by the external application 13, the external application 13 may enable the communications driver 18 to save the contents of the symbolic entry table 15 to a named disk file for future use.

After the symbolic entry table 15 has been created, the external application 13 enables the communications driver 18 to broadcast its availability, including the identification of the symbolic entry table 15 (step 106). When an operator, working in a spreadsheet session provided by the spreadsheet process 10, wishes to make a connection to the external application 13, he enables the spreadsheet application 11 to transfer a connect request to the external process 12. If the external application 13 accepts the connect request, the communications drivers 17 and 18 establish the communications channel 14. In addition, the symbolic entry table 15 is available to the spreadsheet application 13. The contents of the symbolic entry table 15 are also available to the operator of the spreadsheet session, and may be modified by the operator.

After the communications channel 14 has been established (steps 107 and 110, Fig. 2B), the external application 13 can, through communications driver 18, transfer messages to and receive messages from the spreadsheet application 11 over the communications channel 14. The external application may transfer messages that enable the spreadsheet application 11 to load data into (steps 112-117 and 120-123, Figs. 2B and 2C), or that enable the spreadsheet application to return data from (steps 130-137 and 140-141, Figs. 2D and 2E), cells identified in the symbolic entry table 15.

With reference to Fig. 2B, to initiate loading a value into a specified cell in the spreadsheet grid 20, the external application 13 first generates a PUT VALUE message, including an entry identification referencing the cell and the value to be stored therein, and enables the communications driver 18 to transfer it over the communications channel 14 (step 112). The communications driver 17 receives the PUT VALUE message and puts it into the queue 21 for processing (step 113). The queue 21 may have several messages ahead of the PUT VALUE message to process. When the PUT VALUE message gets to the head of the queue in queue 21, the spreadsheet application 11 determines whether the contents of the spreadsheet grid are stable (step 114), and if not, it enables the communications driver to insert a wait status notification into the request status block 16 (step 115), and returns to step 114. If the external application 13 tests the contents of the request status block at this point, it will determine that the request in the PUT VALUE message is pending.

At some point, the spreadsheet grid 20 becomes stable, and the spreadsheet application 11 withdraws the PUT VALUE message from the queue 21 (step 116). The spreadsheet application determines whether the symbolic entry table 15 contains an entry 30 the contents of whose entry identification field 31 matches the entry identification in the PUT VALUE message (step 117). If not, the spreadsheet application inserts the appropriate status in the request status block (step 123, Fig. 2C) and returns to step 111 (Fig. 2B) to process the next message.

On the other hand, if the spreadsheet application determines, in step 117, that an appropriate entry exists in the symbolic entry table 15, it retrieves the cell identification (step 120) and determines whether the cell is locked (step 121). The cell may be locked by the operator during the spreadsheet session. If the cell is locked, the spreadsheet application 11 inserts the appropriate status into the request status block (step 123) and returns to step 111 to process the next message. However, if the spreadsheet application 11 determines in step 121 that the cell is not locked, it loads the value in the PUT VALUE message into the identified cell (step 122). Thereafter, the spreadsheet application inserts the appropriate status into the request status block identified in the message (step 123) and returns to step 111 to process the next message.

The operations performed to enable the spreadsheet application 11 to return data to the external application 13 are depicted in Figs. 2D and 2E. With reference to Fig. 2D, to initiate a return of data from a specified cell in the spreadsheet grid 20, the external application 13 first generates a GET VALUE message, including a symbolic name referencing the cell and the identification of a buffer in which the data from the cell is to be loaded, and enables the communications driver 18 to transfer it over the communications channel 14 (step 130). The communications driver 17 receives the GET VALUE message and puts it into the queue 21 for processing (step 131). When the GET VALUE message gets to the head of the queue in queue 21, the spreadsheet application 11 determines whether the contents of the spreadsheet grid are stable (step 132), and if not, it enables the communications driver to insert a wait status notification into the request status block 16 (step 133), and returns to step 132. If the external application 13 tests the contents of the request status block at this point, it will determine that the request in the GET VAlUE message is pending.

At some point, the spreadsheet grid 20 becomes stable, and the spreadsheet application 11 withdraws the GET VALUE message from the queue 21 (step 134). The spreadsheet application determines whether the symbolic entry table 15 contains an entry 30 the contents of whose entry identification field 31 matches the entry identification in the GET VALUE message (step 135). If not, the spreadsheet application inserts the appropriate status in the request status block (step 140, Fig. 2E) and returns to step 111 (Fig. 2B) to process the next message. The external application 13 proceeds depending on the status in the status request block 16 identified in the message (step 141); at this point, the external application may perform an error recovery operation to attempt to obtain the value from the cell. Eventually, the external application 13 returns to step 111.

On the other hand, if the spreadsheet application determines, in step 135, that an appropriate entry exists in the symbolic entry table 15, it retrieves the cell identification (step 136) from the symbolic entry table 15 and retrieves the value stored therein and loads it into the buffer identified in the GET VALUE message (step 137). Thereafter, the spreadsheet application 11 inserts the appropriate status into the request status block (step 140) and returns to step 111 to process the next message. The external application proceeds depending on the returned status in the request status block (step 141). If the status indicates the operation was successful, that is, that the value is properly contained in the identified buffer, the external application 13 uses the value. On the other hand, if the status indicates that the value was truncated, which may occur if the buffer was not large enough to contain the entire value, the external application 13 may perform an error recovery operation in which it returns to step 130 to generate a GET VALUE message identifying a larger buffer.

In addition, the external application 13 may generate other messages than a PUT VALUE message or a GET VALUE message. The external application 13 may also generate a SET WATCHPOINT message that enables the spreadsheet application to establish a watchpoint in connection with one or more cells in the spreadsheet grid 20. If a message establishes a watchpoint in connection with a cell, the message identifies a user action routine 24 (Fig. 1) which the spreadsheet application 11 uses to notify the external application 13 of the value contained in the cell has changed. The external application 13 may also generate a CANCEL WATCHPOINT message to cancel a watchpoint.

Either the spreadsheet process 10 or the external process 12 may terminate communications over the communications channel 14. An operator using the spreadsheet application 11 in spreadsheet process 10 may terminate communications with a specific communications channel 14 or with all connected communications channels 14 by exiting the spreadsheet application 11, effectively eliminating the communications driver 17 which supports its end of the communications channel 14. The external application 13 may terminate communications by directing the communications driver 18 to close the communications channel 14.

In one embodiment, the system permits the operator, during a spreadsheet session, to control the contents of the entries 30 in the symbolic entry table 15. Thus, the operator may modify the contents of the cell identification fields 32 of an existing entry, and thereafter, the spreadsheet application will store data in a message which identifies the symbolic name contained in the symbolic name field of the changed entry 30 in the cell identified by the newly established contents of the cell identification field 32.

The communications channel 14 may include any conventional mechanism for effecting inter-process communications within a digital data processing system. In one embodiment, the mechanism comprises a mailbox service by which the operating system notifies the applications 11 and 13 in processes 10 and 12, respectively, when they have messages from any other processes waiting for their processing.

The foregoing description has been limited to a specific embodiment of this invention. It will be apparent, however, that variations and modifications may be made to the invention, with the attainment of some or all of the advantages of the invention. Therefore, it is the object of the appended claims to cover all such variations and modifications as come within the true spirit and scope of the invention.

## Claims

1. A system comprising a spreadsheet application an external application and a communications system for transferring messages between said spreadsheet application and said external application, said communications system having an associated symbolic entry table for associating symbolic names with cells;

A. said external application including:

i. a message generator for generating messages each having a symbolic name and identifying an operation;

ii. a message transfer section for transferring messages generated by said message generator over said communications system;

B. said spreadsheet application including:

i. a message transfer section for receiving messages from said communications system; and

ii. a message processor for using the contents of the symbolic entry table associated with the communications system over which the message was received for identifying a cell in response to a symbolic name in a message and for performing the operation specified in said message in connection with the identified cell.

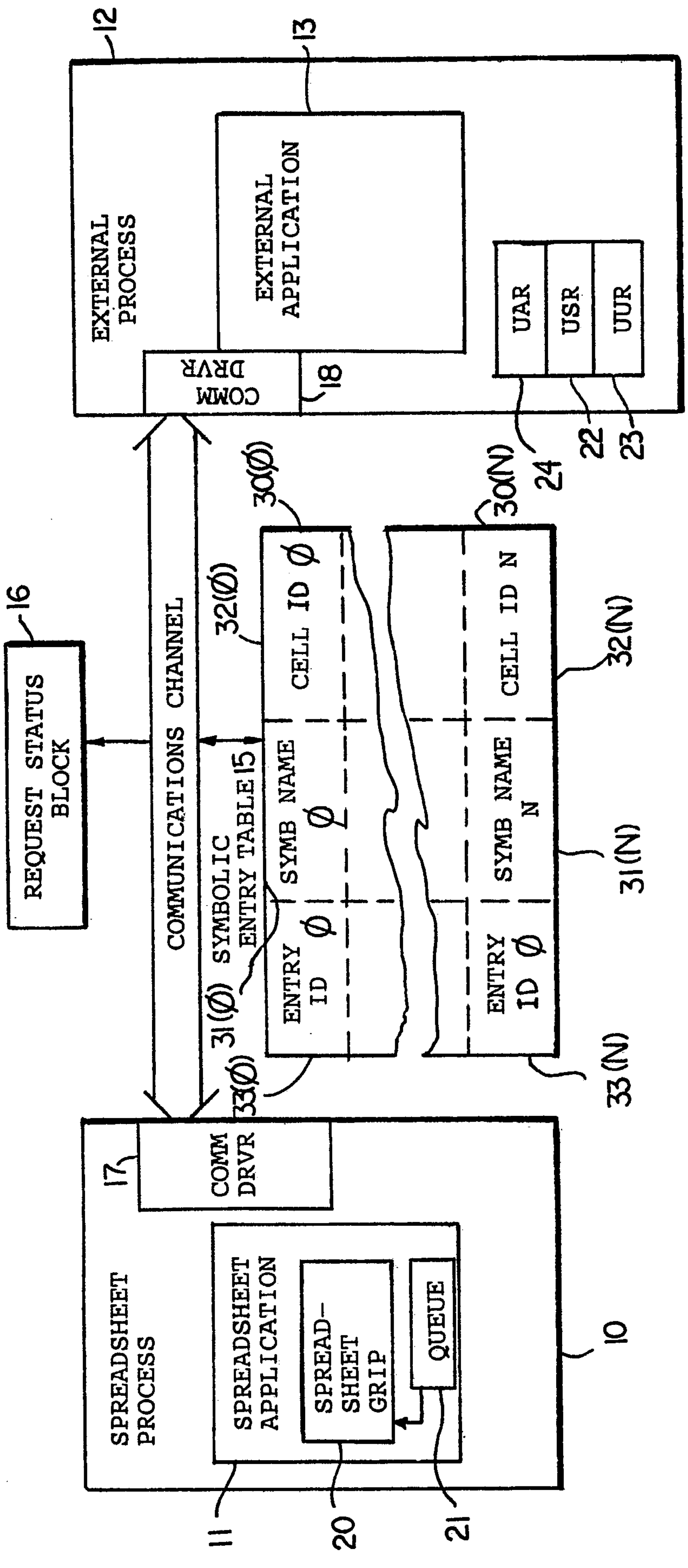
12
13
EXTERNAL PROCESS
EXTERNAL APPLICATION
COMM DRVR
18
UAR
USR
UUR
24
22
23
16
REQUEST STATUS BLOCK
COMMUNICATIONS CHANNEL
SYMBOLIC ENTRY TABLE 15
30(Ø)
32(Ø)
31(Ø)
33(Ø)
ENTRY ID Ø
SYMB NAME Ø
CELL ID Ø
30(N)
ENTRY ID Ø
SYMB NAME N
CELL ID N
32(N)
31(N)
33(N)
17
COMM DRVR
SPREADSHEET PROCESS
SPREADSHEET APPLICATION
SPREAD-SHEET GRIP
QUEUE
10
11
20
21

FIG.1

FIG. 2A

EXTERNAL
APPLICATION
INITIALIZATION

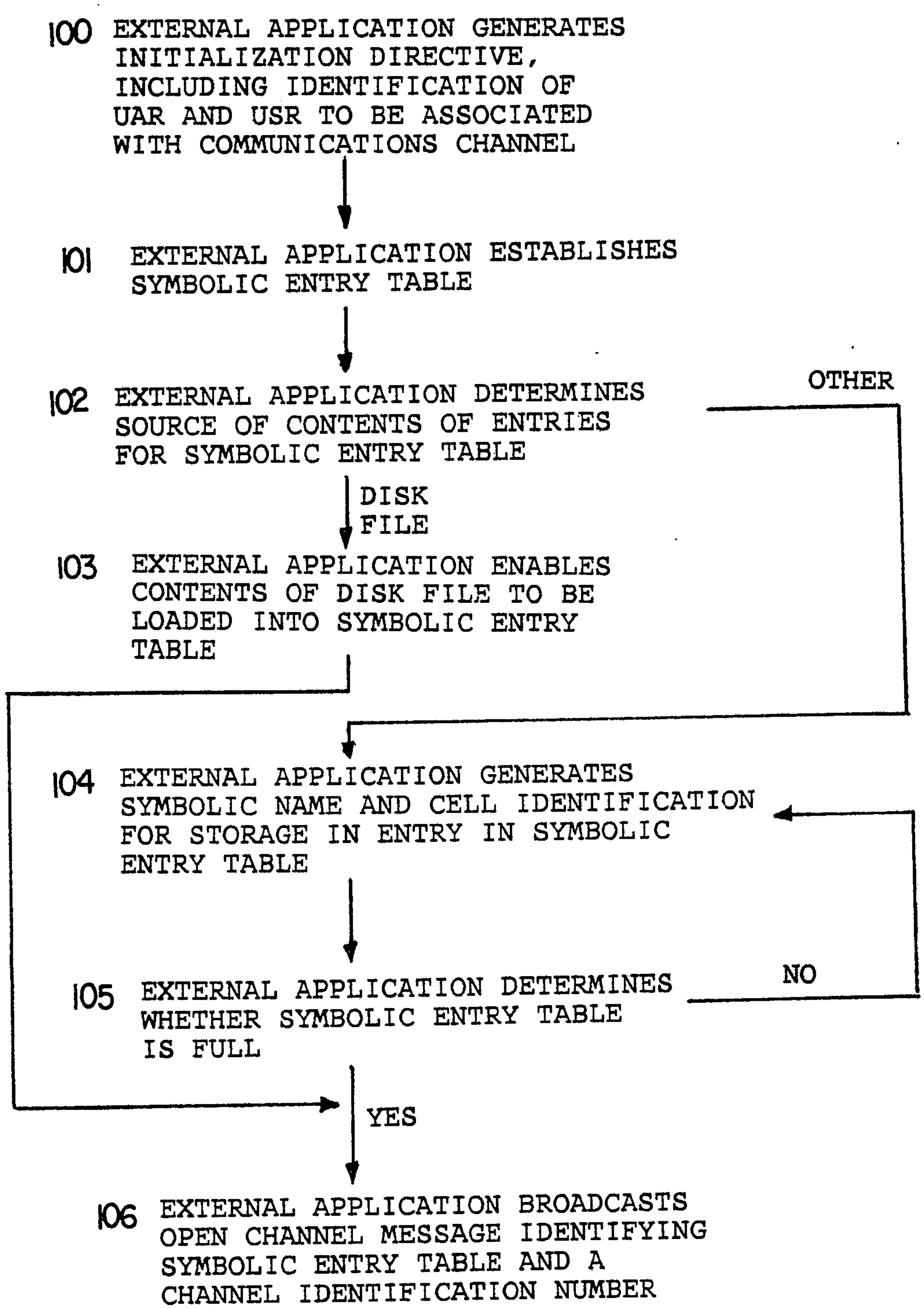

FIG. 2B

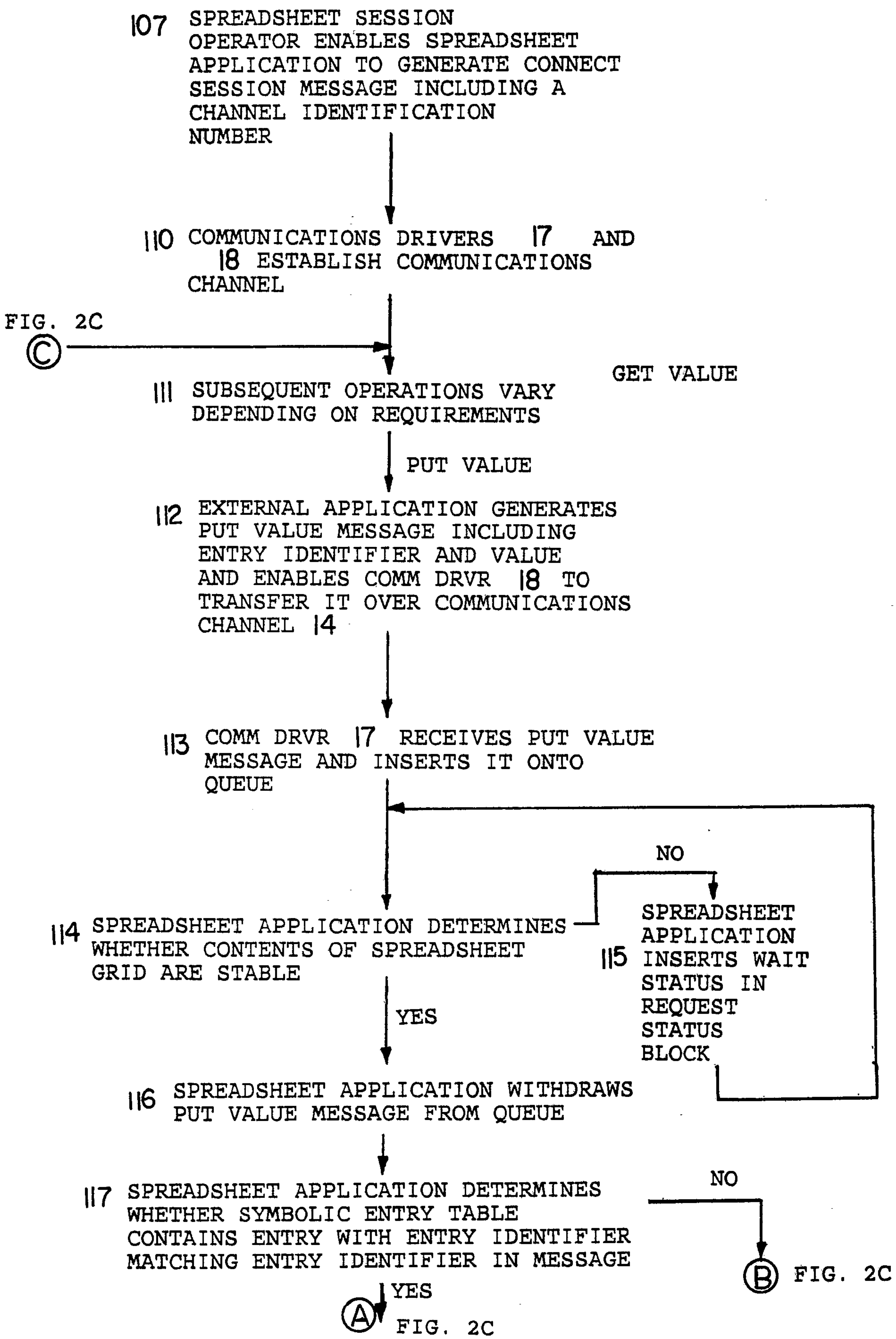
107 SPREADSHEET SESSION OPERATOR ENABLES SPREADSHEET APPLICATION TO GENERATE CONNECT SESSION MESSAGE INCLUDING A CHANNEL IDENTIFICATION NUMBER
110 COMMUNICATIONS DRIVERS 17 AND 18 ESTABLISH COMMUNICATIONS CHANNEL
FIG. 2C
C
111 SUBSEQUENT OPERATIONS VARY DEPENDING ON REQUIREMENTS
GET VALUE
PUT VALUE
112 EXTERNAL APPLICATION GENERATES PUT VALUE MESSAGE INCLUDING ENTRY IDENTIFIER AND VALUE AND ENABLES COMM DRVR 18 TO TRANSFER IT OVER COMMUNICATIONS CHANNEL 14
113 COMM DRVR 17 RECEIVES PUT VALUE MESSAGE AND INSERTS IT ONTO QUEUE
NO
114 SPREADSHEET APPLICATION DETERMINES WHETHER CONTENTS OF SPREADSHEET GRID ARE STABLE
115 SPREADSHEET APPLICATION INSERTS WAIT STATUS IN REQUEST STATUS BLOCK
YES
116 SPREADSHEET APPLICATION WITHDRAWS PUT VALUE MESSAGE FROM QUEUE
117 SPREADSHEET APPLICATION DETERMINES WHETHER SYMBOLIC ENTRY TABLE CONTAINS ENTRY WITH ENTRY IDENTIFIER MATCHING ENTRY IDENTIFIER IN MESSAGE
NO
B
FIG. 2C
YES
A
FIG. 2C

FIG. 2C

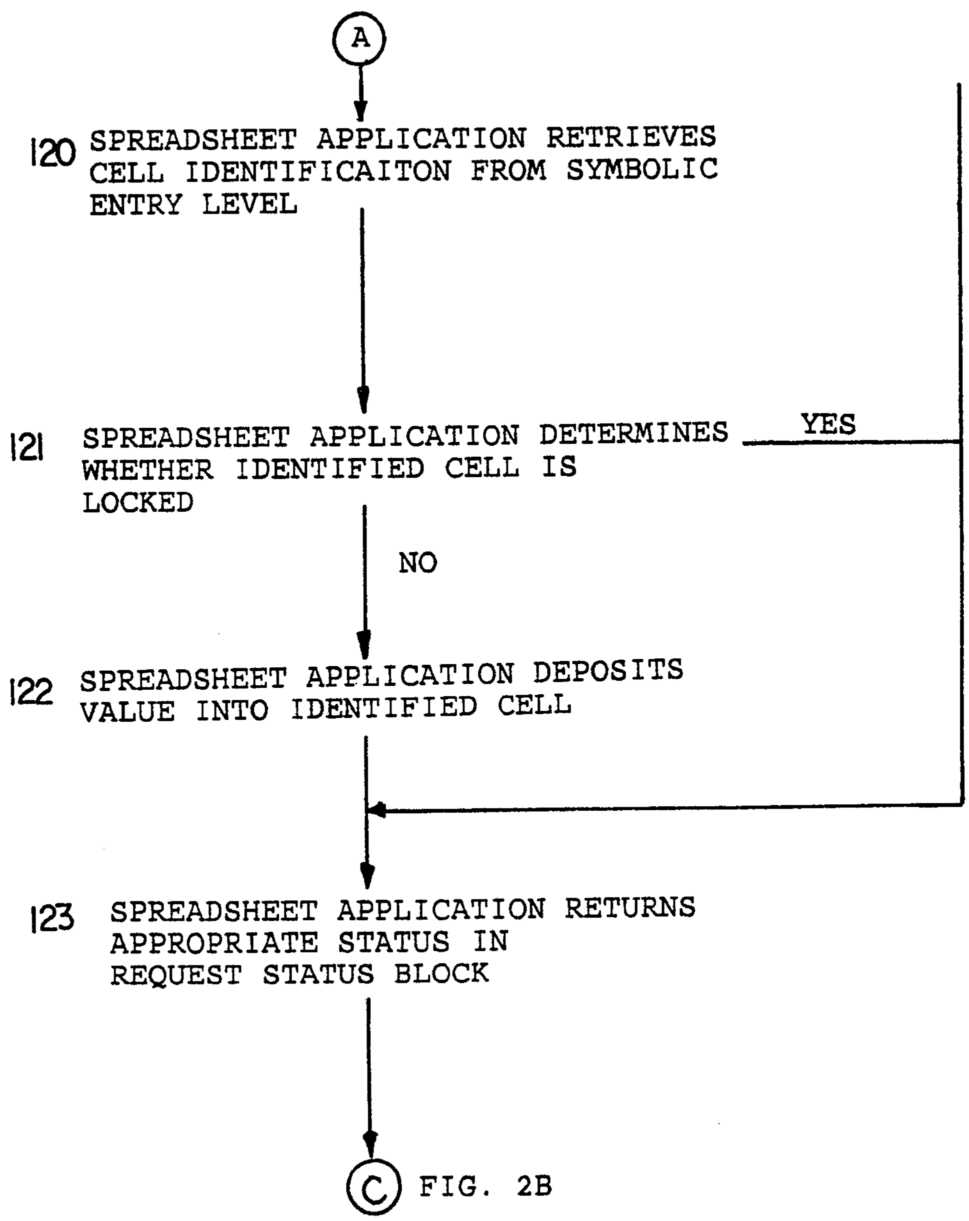
A
120 SPREADSHEET APPLICATION RETRIEVES CELL IDENTIFICAITON FROM SYMBOLIC ENTRY LEVEL
121 SPREADSHEET APPLICATION DETERMINES WHETHER IDENTIFIED CELL IS LOCKED
YES
NO
122 SPREADSHEET APPLICATION DEPOSITS VALUE INTO IDENTIFIED CELL
123 SPREADSHEET APPLICATION RETURNS APPROPRIATE STATUS IN REQUEST STATUS BLOCK
C

FIG. 2B

FIG. 2D

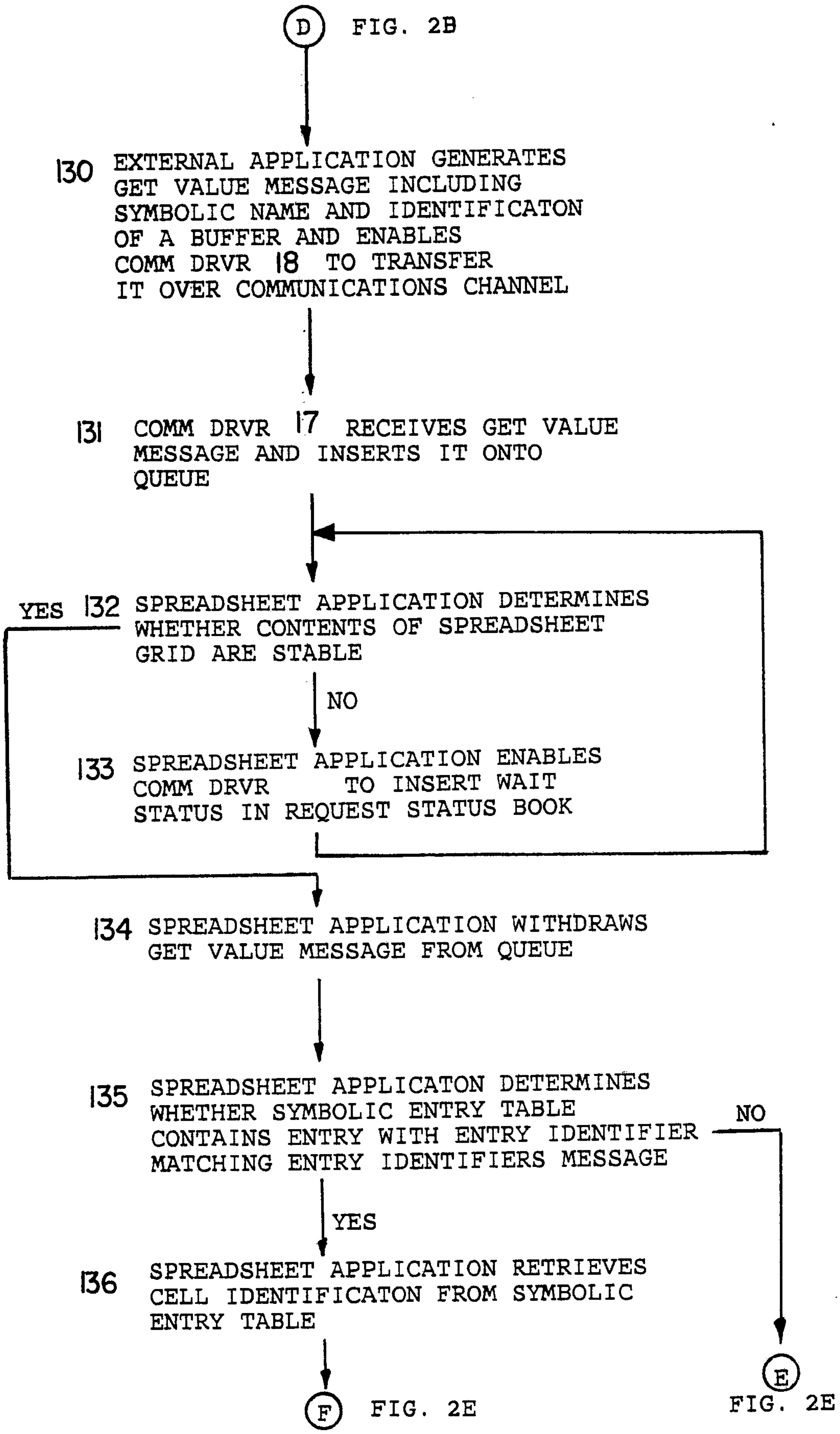
D
FIG. 2B
130 EXTERNAL APPLICATION GENERATES GET VALUE MESSAGE INCLUDING SYMBOLIC NAME AND IDENTIFICATON OF A BUFFER AND ENABLES COMM DRVR 18 TO TRANSFER IT OVER COMMUNICATIONS CHANNEL
131 COMM DRVR 17 RECEIVES GET VALUE MESSAGE AND INSERTS IT ONTO QUEUE
132 SPREADSHEET APPLICATION DETERMINES WHETHER CONTENTS OF SPREADSHEET GRID ARE STABLE
YES
NO
133 SPREADSHEET APPLICATION ENABLES COMM DRVR TO INSERT WAIT STATUS IN REQUEST STATUS BOOK
134 SPREADSHEET APPLICATION WITHDRAWS GET VALUE MESSAGE FROM QUEUE
135 SPREADSHEET APPLICATON DETERMINES WHETHER SYMBOLIC ENTRY TABLE CONTAINS ENTRY WITH ENTRY IDENTIFIER MATCHING ENTRY IDENTIFIERS MESSAGE
NO
YES
136 SPREADSHEET APPLICATION RETRIEVES CELL IDENTIFICATON FROM SYMBOLIC ENTRY TABLE
F
FIG. 2E
E
FIG. 2E

FIG. 2E

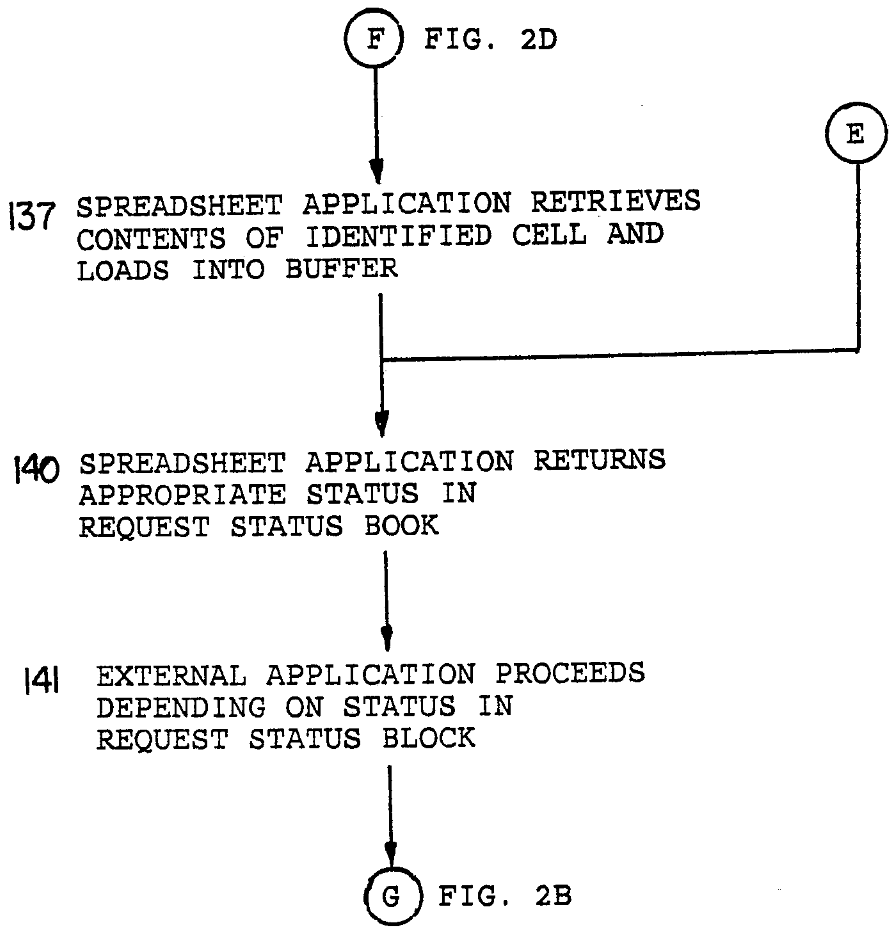
F
FIG. 2D
E
137 SPREADSHEET APPLICATION RETRIEVES CONTENTS OF IDENTIFIED CELL AND LOADS INTO BUFFER
140 SPREADSHEET APPLICATION RETURNS APPROPRIATE STATUS IN REQUEST STATUS BOOK
141 EXTERNAL APPLICATION PROCEEDS DEPENDING ON STATUS IN REQUEST STATUS BLOCK
G
FIG. 2B